(19) **Europäisches Patentamt / European Patent Office / Office européen des brevets**

(11) **EP 4 379 792 A1**

(12) # EUROPEAN PATENT APPLICATION
published in accordance with Art. 153(4) EPC

(43) Date of publication:
**05.06.2024 Bulletin 2024/23**

(21) Application number: **21951758.8**

(22) Date of filing: **26.07.2021**

(51) International Patent Classification (IPC):
**H01L 23/36** $^{(2006.01)}$

(52) Cooperative Patent Classification (CPC):
**H01L 23/36**

(86) International application number:
**PCT/JP2021/027530**

(87) International publication number:
**WO 2023/007546 (02.02.2023 Gazette 2023/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **MITSUBISHI ELECTRIC CORPORATION**
**Chiyoda-ku**
**Tokyo 100-8310 (JP)**

(72) Inventors:
• **OMAE, Katsuhiko**
  **Tokyo 100-8310 (JP)**
• **TAKEUCHI, Kensuke**
  **Tokyo 102-0073 (JP)**

(74) Representative: **Hoffmann Eitle**
**Patent- und Rechtsanwälte PartmbB**
**Arabellastraße 30**
**81925 München (DE)**

(54) **ELECTRONIC DEVICE AND ELECTRIC POWER STEERING DEVICE**

(57) An electronic device includes: a substrate having a circuit pattern; heating elements disposed on a top of the substrate, and that have upper surface heat dissipating portions that are located on an opposite side of the substrate; thermal conductive members that are disposed on a top of the upper surface heat dissipating portions; metallic plates that are disposed on a top of the thermal conductive members; thermal conductive insulators that are disposed on a top of the metallic plates, and a heat sink that is disposed on a top of the thermal conductive insulators.

FIG. 1

EP 4 379 792 A1

**Description**

[Technical Field]

The present disclosure relates to an electronic device and an electric power steering device.

[Background Art]

A conventional electric power steering device is described in Patent Document 1.

For example, a conventional electronic device includes a substrate that has a circuit pattern, heating elements that, along with having heat spreaders, are mounted on the substrate, thermal conductive insulators that transmit heat generated from the heating elements, and a heat sink that dissipates the heat to an outside of the electronic device.

In the conventional electronic device disclosed in Patent Document 1, it is suggested that heat generated by the heating elements be dissipated from a back surface of the heating elements. For example, in Patent Document 1 FIG. 12, a structure where a heat dissipating gel is filled between heating elements and a heat sink (equivalent to a "frame" in Patent Document 1) is described.

[Citation List]

[Patent Document]

[Patent Document 1]
Japanese Patent No. 6160576

[Summary of Invention]

[PROBLEM TO BE SOLVED BY THE INVENTION]

With the evolution of semiconductor processes, downsizing of heating elements that are represented in power MOS-FETs is advancing. For such reason, sizes of packages that include heating elements is decreasing. As a result, surface areas of heat spreaders that dissipate heat from the heating elements is becoming smaller. An increase in the thermal conductivity of a heat dissipating gel is not to be counted on, and there is a limit as to how much the thermal resistivity from the heating elements to the heat spreaders can be reduced.

In a structure where heat is dissipated from a rear surface of a substrate via through holes formed on the substrate, there is a limit as to how much it is possible to decrease the thermal resistivity, since a thickness of copper film formed on inner walls of a plurality of through holes is thin.

The present disclosure has been made in order to address the problems above, and an object is to provide a low cost electronic device that dissipates heat generated from heating elements mounted on a substrate efficiently without interfering with downsizing of the heating elements, and an electric power steering device included with the aforementioned electronic device.

[MEANS TO SOLVE THE PROBLEM]

An electronic device according to the present disclosure includes: a substrate having a circuit pattern; heating elements disposed on a top of the substrate, and that have an upper surface heat dissipating portion that is located on an opposite side of the substrate; thermal conductive members that are disposed on a top of the upper surface heat dissipating portion; metallic plates that are disposed on a top of the thermal conductive members; thermal conductive insulators that are disposed on a top of the metallic plates, and a heat sink that is disposed on a top of the thermal conductive insulators.

[EFFECTS OF THE INVENTION]

In an electronic device according to the present invention, it is possible to provide an electronic device that efficiently dissipates heat generated from heating elements mounted on a substrate while not interfering with the downsizing of the electronic device.

[Brief Description of Drawings]

[FIG. 1] A cross-sectional view that shows a configuration of an electronic device according to a first embodiment.
[FIG. 2] A cross-sectional view that shows a configuration of the electronic device according to the first embodiment, and that shows a modification example of a metallic plate.
[FIG. 3] A cross-sectional view that shows a configuration of the electronic device according to the first embodiment, and that shows a modification example of a metallic plate.
[FIG. 4A] A plan view that shows a configuration of the electronic device according to a second embodiment.
[FIG. 4B] A cross-sectional view taken along a line A-A of FIG. 4A that shows a configuration of the electronic device according to the second embodiment.
[FIG. 4C] A cross-sectional view taken along a line B-B of FIG. 4B that shows a configuration of the electronic device according to the second embodiment.
[FIG. 4D] A plan view of a modification example of the electronic device according to the second embodiment.
[FIG. 4E] A cross-sectional view taken along a line C-C of FIG. 4C that shows a modification example of the electronic device according to the second embodiment.
[FIG. 4F] A cross-sectional view that shows a modification example of the electronic device according to the second embodiment, and shows an enlarged view of reference sign D in FIG. 4D.

[FIG. 5A] A cross-sectional view that shows a configuration of the electronic device according to the second embodiment.

[FIG. 5B] A cross-sectional view taken along a line C-C of FIG. 5A that shows a configuration of the electronic device according to the second embodiment.

[FIG. 6] A circuit block diagram that shows a configuration of an electric power steering device that includes an electronic device according to a third embodiment.

[FIG. 7] An exploded view that shows of a plurality of parts that configure the electric power steering device which includes the electronic device according to the third embodiment.

[FIG. 8A] An inclined view that shows a substrate that configures the electric power steering device which includes the electronic device according to the third embodiment.

[FIG. 8B] An inclined view that shows the substrate that configures the electric power steering device which includes the electronic device according to the second embodiment, and shows an enlarged view of a portion shown with reference sign D in FIG. 8A.

[FIG. 9] An exploded view of a redundant electric power steering device according to a fourth embodiment.

[Description of Embodiments]

(Thermal design)

Before explaining embodiments, fundamental considerations of a thermal design are explained.

The downsizing of heating elements that are representative of power MOS-FETs is advancing. As the downsizing of heating elements having a performance similar to or greater than current heating elements advances, a packing density of the electronic device that uses parts which include the heating elements is improved, and it is possible to sufficiently downsize the electronic device.

However, when a package (for example, an FET package) that includes heating elements is downsized, a surface area of heat spreaders from which heat of the heating elements is dissipated is reduced. When the performance of the heating elements does not change, an amount of heat dissipated from the heating elements is the same.

Conventionally, a structure where heat is dissipated via thermal insulation grease that is applied between heating parts (heating elements) and a heatsink is known. The heat dissipating function of the heat dissipating structure is determined by the thermal resistivity from the heating parts to the heat sink and the outside air.

In a structure where FETs dissipate heat to the heatsink, a case where heat is dissipated from the FETs (heating elements, heating parts) that includes heat spreaders on an upper surface, a substrate that has the FETs mounted on the substrate, the heatsink, and thermal insulation members provided between the FETs and the heatsink is taken into consideration as an example.

The thermal resistivity Rθ from the heating parts which are FETs to the heat sink is expressed by the following equation:

$$R\theta = t/(S \times \lambda) \ [°C/W]$$

"t" represents a thickness [m] of a thermal conductive insulator.

"S" represents an area of the thermal conductive insulator (heat spreader area) $[m^2]$.

"λ" represents a thermal conductivity of the thermal conductive insulator [W/m K].

In the above, the thermal resistivity of the heat spreaders is neglected.

The thermal resistivity of the heat spreaders is neglected for the reason outlined below.

The heat spreaders are usually made of copper. The thermal conductivity of copper is 400[W/m K]. The thermal conductivity of the thermal conductive insulators is roughly 10W/m K at most. For such reason, the order of magnitude between the thermal conductivity of the thermal conductive insulators is different from that of the thermal conductivity of copper. For such a reason, even if the thermal resistivity of the heat spreaders is ignored, the effects on the thermal resistivity Rθ are negligible.

With the equation above, three methods exist to downsize the value of the Rθ.

(Method 1) Downsizing the thickness "t" of the thermal conductive insulator.
(Method 2) Making the area "S" of the thermal conductive insulator larger.
(Method 3) Making the thermal conductivity "λ" of the thermal conductive insulator larger.

Next, the three methods above are explained.

(Method 1)

Usually, the heat spreader of an FET is electrically conductive with inner electrodes of the FET. There is a need to electrically insulate the heat spreader and the heat sink. Therefore, in order to obtain electric conductive insulation, usually a thermal insulation grease, an adhesive, a sheet or the like is used. To insure electrical insulation while downsizing the thickness t of the thermal conductive insulator, high precision is required in the forming and assembling of a structure that dissipates heat (heat dissipating components, heat dissipating structure, heat dissipating channel). Further, there is a limit to how much the thickness t of the thermal conductive insulator may be downsized, and high precision is required.

(Method 2)

The area S of the thermal conductive insulator is determined by the area of the heat spreader of the FET. For such reason, it is not possible to make the area S larger. Further, since making the FET package larger in order to make the area of the heat spreader larger contradicts the purpose of downsizing, such method is not realistic.

(Method 3)

The thermal conductivity of the thermal insulation grease, the adhesive, the sheet or the like is roughly 10W/m K at most. Although higher values of thermal conductivities of the above exist, such thermal conductive insulators are extremely costly, and are thus not suited for mass production design.

Hereinafter, a design of a heating element package (FET package) that considers the constraints of the above mentioned three methods without impeding downsizing and heat dissipating function, while improving a structure thereof is proposed.

First Embodiment

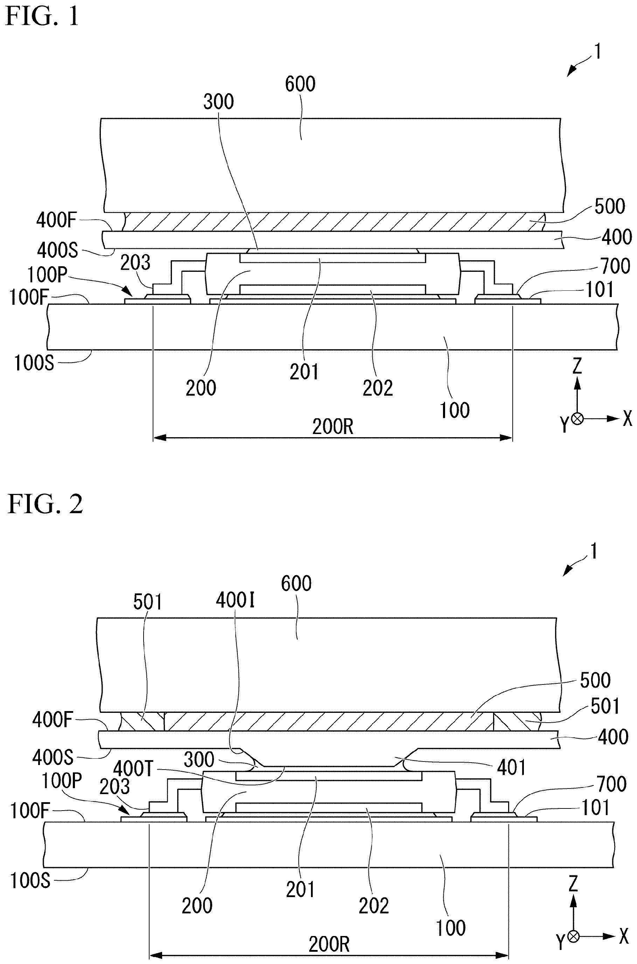

An electronic device 1 according to a first embodiment is explained with reference to FIG. 1.

In an explanation of modification examples 1 to 4 to be mentioned later on, a direction of thickness of the electronic device 1 (in other words, a thickness of a substrate 100) is referred to as a Z direction. A direction orthogonal to the Z direction is referred to as an X direction and a Y direction.

With regards to dimensions of various components to be mentioned later on, a "thickness" refers to a distance in the Z direction. An "area" refers to areas of parallel surfaces in the X direction and in the Y direction.

A "contact area" refers to an area where two components contact one another.

As shown in FIG. 1, the electronic device 1 includes the substrate 100, a heating element 200 of heating elements 200, a thermal conductive member 300 of thermal conductive members 300, a metallic plate 400 of metallic plates 400, a thermal conductive insulator 500 of the thermal conductive insulators 500, and a heat sink 600.

<Substrate>

The substrate 100 is for example a well-known printed circuit board. A circuit pattern 100P is formed on a top of the substrate 100. As shown in the example of FIG. 1, the circuit pattern 100P is formed on a top of a surface 100F (a first surface, upper surface) out of surfaces of the substrate 100. A structure of the substrate 100 is one where the plurality of components 200, 300, 400, 500 and 600 previously mentioned are stacked in such order in the surface 100F out of surfaces of the substrate 100. In the explanation below, the surface 100F out of surfaces of the substrate 100 is referred to as a "first surface 100F".

Connection terminals 101 that form a part of the circuit pattern 100P are formed on top of the first surface 100F of substrate 100. Locations in which the connection terminals 101 are formed on top of the first surface 100F correspond to a design of the electronic device 1, and may be changed appropriately. For example, the connection terminals 101 may be formed in locations that correspond to the location of element terminal 203 of the heating element 200.

Components different than the plurality of components 200, 300, 400, 500 and 600 previously mentioned may be disposed on the top of substrate 100. For example, a controller (control circuit or IC chip or the like) that controls the heating element 200 may be mounted on a top of the substrate 100. In such case, the controller may be connected to the circuit pattern 100P of the substrate 100. The circuit pattern may also be formed on another surface 100S (a second surface, opposite to the first surface, i.e. a back side) of the substrate 100. In the explanation below, the other surface 100S is referred to as a second surface 100S.

<Heating Elements>

The heating element 200 is disposed on the top of the substrate 100. The heating element 200 is mounted on the first surface 100F of the substrate 100. The heating element 200 is for example, a power MOS-FET. It is also possible to collectively refer to the heating elements 200 as "power elements". FET chips are built into the power MOS-FETs. In the explanation below, there are cases where the heating elements are referred to as power MOS-FETs, or as FETs. The heating element 200 has a drain electrode, a source electrode, and a gate electrode (control terminal).

The heating element 200 includes an upper surface heat spreader 201 (upper surface heat dissipating portion), a lower surface heat spreader 202 (substrate facing surface), and an element terminal 203. The upper surface heat spreader 201 faces the metallic plate 400.

In other words, the upper surface heat spreader 201 is located on an opposite side to the first surface 100F of the substrate 100.

The lower surface heat spreader 202 faces the first surface 100F of the substrate 100. The element terminal 203 corresponds to a lead wire terminal that extends from the opposite surface of the heating element 200. The location of the element terminal 203 corresponds to the location of the connection terminal 101 of the substrate 100. The element terminal 203 is joined by soldering to the connection terminal 101.

The element terminal 203 is a terminal for controlling the heating element 200. A control signal to control the heating element 200 is input to the heating element 200 through the circuit pattern 100P of the substrate 100, the connection terminal 101, and the element terminal 203. The heating element 200 are entirely covered with resin. In other words, the heating element 200 is packaged by the resin.

Although a structure where the heating element 200 includes a lower surface heat spreader 202 is shown in the example of FIG. 1, heat dissipation from an upper surface heat spreader 201 to the metallic plate 400 in the current embodiment is explained.

<Thermal Conductive Members>

The thermal conductive member 300 is disposed on the upper surface heat spreader 201. The thermal conductive member 300 is provided between the upper surface heat spreader 201 and the metallic plate 400. The thermal conductive member 300 is thermally and mechanically joined to the upper surface heat spreader 201 and the metallic plate 400. In other words, the thermal conductive member 300 is a joining member that joins the upper surface heat spreader 201 and the metallic plate 400. As a material of the thermal conductive members 300, a metallic material such as solder, silver paste or the like, which has a high thermal conductivity, may be adopted. A material that has electrical conductive properties may be used as the material for the thermal conductive member 300.

Thermal conductivity of the thermal conductive member 300 is larger than the thermal conductivity of the thermal conductive insulator 500.

For example, in a case where a solder is used as the thermal conductive member 300, the thermal conductivity of the solder is about 50 W/m K. Furthermore, it is possible to freely set the thickness of the solder, and it is possible to make the thickness of the solder thin. For such reason, it is possible to make a heat resistance of the solder smaller.

<Metallic Plates>

The metallic plate 400 is disposed on the upper surface heat spreader 201.

As a material that configure the metallic plate 400 for example, a metal having excellent thermal conductivity, such as copper or the like is used. In a case where copper is used as the metallic plate 400, the thermal conductivity of copper is about 400W/m K. It is preferable that a thickness of the metallic plate 400 be within the range of 0.5mm to 1.0mm for example. The thickness of the metallic plate 400 is not limited to the range mentioned above.

In the example of FIG. 1, the metallic plate 400 is shaped as a flat plate.

The metallic plate 400 has a first metallic surface 400F, and a second metallic surface 400S which is an opposing surface to the first metallic surfaces 400F.

The first metallic surface 400F contacts the thermal conductive insulator 500. The second metallic surface 400S contacts the thermal conductive member 300.

Since the metallic plate 400 is shaped as a flat plate, each of the first metallic surface 400F and the second metallic surface 400S is a flat surface.

The thickness of the metallic plate 400 is set after taking into consideration the thermal conductivity of the metallic plate 400.

The metallic plate 400 has electrodes that have same electrical potentials as that of electrodes out of the drain electrodes or the source electrodes of the heating element 200. For such reason, when the metallic plate 400 is electrically connected to the heat sink 600, a short circuit is generated via the heat sink 600. To avoid the short circuit mentioned above, the metallic plate 400 needs to be electrically insulated from the heat sink 600.

It is possible to freely set an area of the metallic plate 400. For example, it is possible to make the area of the metallic plate 400 larger than an area of the heating element 200 (an area of the upper surface heat spreader 201). It is also possible to make a contact surface of the thermal conductive insulator 500 with respect to the metallic plate 400 be larger.

<Thermal Conductive Insulators>

The thermal conductive insulator 500 is disposed on top of the metallic plate 400. The thermal conductive insulator 500 is filled between the metallic plate 400 and the heat sink 600.

The thermal conductive insulator 500 is a member that conducts heat from the metallic plate 400 to the heat sink 600. The thermal conductive insulator 500 is a member that electrically insulates the metallic plate 400 and the heat sink 600. As the thermal conductive insulator, a well-known material such as a heat conductive grease or a heat conductive adhesive may be used. Usually, a thermal conductivity of the thermal conductive insulator 500 is roughly 10W/m K at most.

It is possible to freely set the shapes of the thermal conductive insulator 500. Furthermore, it is possible to freely adjust an area of the thermal conductive insulator 500. For example, it is possible to make a thickness of the thermal conductive insulator 500 be thin so as to correspond to a distance of a gap between the metallic plate 400 and the heat sink 600.

An area of contact between the metallic plate 400 and the thermal conductive insulator 500 is larger than the area of contact between the heating element 200 and the thermal conductive member 300.

<Heat Sink>

The heat sink 600 is disposed on top of the thermal conductive insulator 500. As a construction of the heat sink 600, for example, a well-known construction that includes a plurality of fins may be adopted. As a material that configures the heat sink 600, a metal having excellent thermal conductivity such as copper, aluminum, or the like for example, may be adopted.

<Effect>

Next, effects of the electronic device 1 are explained below.

The heating element 200 generates heat as the control signal is supplied from the substrate 100 to the heating element 200. Heat generated by the heating element 200 is transmitted from the upper surface heat spreader 201 to the metallic plate 400 via the thermal conductive member 300. Since the metallic plate 400 has a high thermal conductivity, the heat that is transmitted to the metallic plate 400 is first spread in the X direction and in the Y direction.

The heat that is spread on an inside of the metallic plate 400 is transmitted to the heat sink 600 via the thermal conductive insulator 500. As previously mentioned, although a decrease in the heat resistivity of the thermal conductive insulator 500 cannot be expected by the thermal conductivity of the thermal conductive insulator 500 (roughly 10W/m K at most), it is possible to make the area of the metallic plate 400 larger than the area of the upper surface heat spreader 201 of the heating element 200. By making the area of the metallic plate 400 larger than the area of the upper surface heat spreader 201, the heat dissipating area increases, and it is possible to more efficiently dissipate heat. For such reason, it is possible to make the heat resistivity in the electronic device 1 smaller by the metallic plate 400.

Specifically, a size of the metallic plate 400, in other words, the area of the metallic plate 400 is set such that a region 200R which includes the heating element 200 and the element terminal 203, and the metallic plate 400 are overlapping, as seen from the Z direction. As such, it is possible to make the heat resistivity in the electronic device 1 smaller without changing mounting density over the entirety of the electronic device 1.

By making the thickness of the thermal conductive insulator 500 smaller, it is possible to decrease the heat resistivity of the electronic device 1. However, regarding the aforementioned point, since there is a need to secure the electric conductive insulation obtained by the thermal conductive insulator 500, the construction of the thermal conductive insulator 500 needs to be taken into consideration.

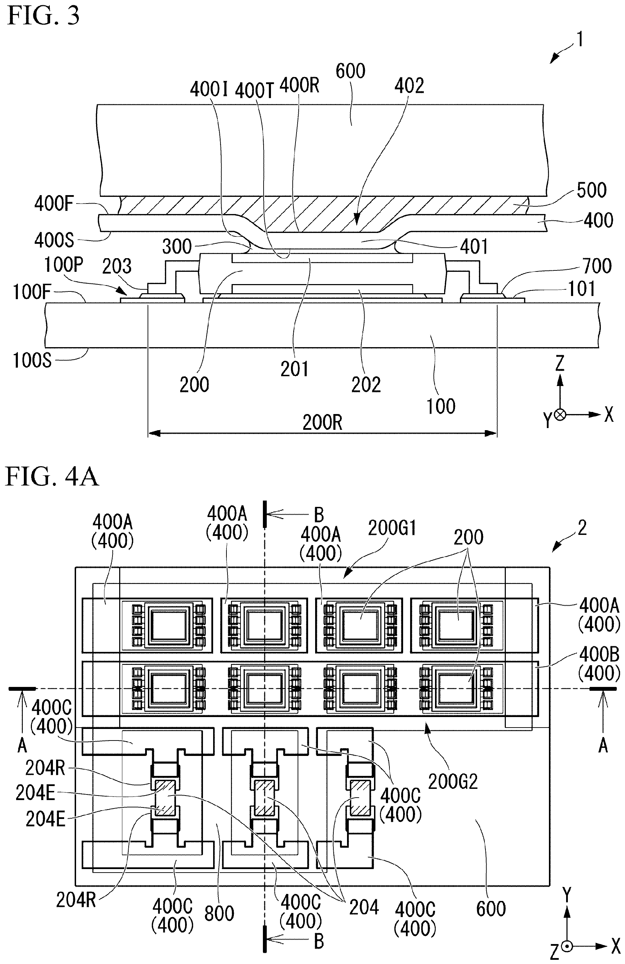

Next, a modification example of the first embodiment is explained with reference to FIG. 2 and FIG. 3. In FIG. 2 and FIG. 3, same components as components of the electronic device 1 shown in FIG. 1 have same reference signs affixed to them, and explanations thereof are omitted.

<First Modification Example of First Embodiment>

As shown in FIG. 2, a metallic plate 400 has a protrusion 401.

The protrusion 401 is a portion that extend from the second metallic surface 400S towards the heating element 200.

It is possible to appropriately adjust a height of the protrusion 401, in other words, a distance from the second metallic surface 400S to an end surface 400T of the protrusion 401 in the Z direction. An inclined surface 400I is formed between the second metallic surface 400S and the end surface 400T.

From such a configuration, it is possible not only to obtain same or similar effects as the effects of the previously mentioned electronic device 1 according to the first embodiment, but to also for example have a case where, a distance between the substrate 100 and the second metallic surface 400S of the metallic plate 400 is made large, be viable.

A solder is used as the thermal conductive member 300. For such reason, it is possible to freely adjust a shape of the solder in between the upper surface heat spreader 201 and the metallic plate 400. In the first modification example, a solder is formed between the end surface 400T of the protrusion 401 and the upper surface heat spreader 201, and between the inclined surface 400I and the upper surface heat spreader 201. A curved surface is formed on an exposed portion of the solder that is exposed in a space between the metallic plate 400 and the heating element 200. In other words, the solder is formed so as to have a fillet shape. By the solder having a fillet shape, it is possible to improve the reliability of joining between the upper surface heat spreader 201 and the metallic plate 400.

The first modification example of the metallic plate differs from the previously mentioned first embodiment in the aspect of the structure of the metallic plate that is formed between the heat sink 600 and the metallic plate 400.

Specifically, a spacer 501, and the thermal conductive insulator 500 is disposed between the heat sink 600 and the metallic plate 400. A well-known insulation material is used as the material of the spacer 501. The spacer 501 has enough strength which is required to retain the gap that is formed between the heat sink 600 and the metallic plate 400.

In a construction that uses the spacer 501, the spacer 501 is first directly fixed to a surface of the heat sink 600 that faces the metallic plate 400. Afterwards, the heat sink 600 and the metallic plate 400 are joined so as to sandwich the spacer 501. As such, the gap between the metallic plate 400 and the heat sink 600 is determined by the thickness of the spacer 501. Further, the thermal conductive insulator 500 is filled in the gap formed by the spacer 501 in between the metallic plate 400 and the heat sink 600.

According to the above configuration, it is possible to assuredly form the gap, into which the thermal conductive insulator 500 is filled, by the spacer 501. Even in a case where a soft material such as a grease or the like is adopted as the material of the thermal conductive insulator 500, it is possible to fill the gap formed by the spacer 501 with the thermal conductive insulator 500.

For example, it is preferable that a location in which the spacer 501 is formed in be a location that encircles a surrounding region of the thermal conductive insulator 500. As such, it is possible to fill the gap surrounded by the spacer 501 in the X direction and in the Y direction with the thermal conductive insulator 500.

<Second Modification Example of First Embodiment>

As shown in FIG. 3, the metallic plate 400 has the protrusion 401, recess 402, and the inclined surface 4001.

The protrusion 401 is a portion that protrudes towards the heating element 200 from the second metallic surface 400S, as is shown in the structure in FIG. 2. The inclined surface 4001 is formed between the second metallic surface 400S and the end surface 400T, as is shown in the structure in FIG. 2.

The recess 402 is a portion that is depressed from the first metallic surface 400F towards the heating element 200. It is possible to appropriately adjust a depth of the recess 402, in other words, a distance from the first metallic surface 400F to bottom surface 400R of the recess 402.

As a method of forming the recess 402, a well-known method using press working, where the recess 402 is formed on a flat plate of the metallic plate 400 shown in FIG. 1, may be mentioned.

From such a configuration, not only is it possible to obtain same or similar outcomes from the electronic device 1 according to the previously mentioned first embodiment and the first modification example, but it is possible to easily form the protrusion 401 and the recess 402 from the flat plate of the metallic plate 400, making it possible to decrease machining cost.

Since it is possible to fill the thermal conductive insulator 500 into the recess 402, it is possible to improve connection reliability between the metallic plate 400 and the heat sink 600.

Second Embodiment

In the previously mentioned first embodiment, a case where one electronic device 1 includes one heating element 200 is described. In a second embodiment, an electronic device that includes a plurality of heating elements is described with reference to FIG. 4A to FIG. 4C.

In FIG. 4A to FIG. 4C, same components as components of the electronic device 1 shown in FIG. 1 to FIG. 3 have same reference signs affixed to them, and explanations thereof are omitted.

As shown in FIG. 4A to FIG. 4C, an electronic device 2 includes eight heating elements 200 which function as power MOS-FETs, and three shunt resistors 204 (heat generating parts). The eight heating elements 200 and the three shunt resistors 204 are provided on the top of the substrate 100. The shunt resistors are heat generating parts that generate heat.

Four heating elements 200 are arranged along the X direction in the electronic device 2. Two heating elements 200 are arranged along the Y direction.

The upper surface heat spreader 201 of each of the eight heating elements 200, functions as a drain electrode.

The four heating elements 200 that are arranged in the X direction form one group of elements. In other words, in the example shown in FIG. 4A, the electronic device 2 includes two groups of elements (a first element group 200G1, a second element group 200G2). Four first metallic plates 400A are connected to the first element group 200G1. One second metallic plate 400B is connected to the second element group 200G2. The first metallic plate 400A and the second metallic plate 400B are aligned in the Y direction, and each function as separate wires. The second element group 200G2 is disposed between the first element group 200G1 and the shunt resistors 204 in the Y direction.

<First Element Group and First Metallic Plate Connection Structure>

The four heating elements 200 (a plurality of first heating elements, a plurality of heating elements) that configure the first element group 200G1 are connected to four first metallic plates 400A via the thermal conductive members 300. Each of the four heating elements 200 has the upper surface heat spreader 201 (first upper surface heat dissipating portion, upper surface heat dissipating portion) that is located on an opposite side to the substrate 100. The four first metallic plates 400A are disposed on a top of the thermal conductive members 300, and are disposed along the arrangement direction (X direction) of the four heating elements 200. The four first metallic plates 400A are mutually separated from one another.

In the first element group 200G1, upper surface heat spreaders 201 are connected to the four first metallic plates 400A via the thermal conductive members 300. In other words, the upper surface heat spreader 201 of one of the heating elements 200 is electrically connected to one of the first metallic plates 400A via the thermal conductive member 300. Since the four first metallic plates 400A are each independently electrically connected, the four upper surface heat spreaders 201 of the heating elements 200 are not mutually continuous. Therefore, electrical potentials of the four upper surface heat spreaders 201 of the four heating elements 200 are different from one another. In other words, in the first element group 200G1, regarding the electrical potentials, the upper surface heat spreaders 201 (drain electrodes).are each independent from one another.

<Second Element Group and Second Metallic Plate Connection Structure>

The four heating elements 200 (a plurality of second heating elements, a plurality of heating elements) that configure the second element group 200G2 are connected to a single second metallic plate 400B via the thermal conductive members 300. Each of the four heating elements 200 has the upper surface heat spreader 201 (second upper surface heat dissipating portion, upper surface heat dissipating portion) that is located on the opposite side to the substrate 100. The second metallic plate 400B is disposed on the top of the thermal conductive members 300, and is disposed along the arrangement direction (X direction) of the four heating elements 200. The second metallic plate 400B and the four heating elements 200 are mutually continuous. The second metallic plate 400B is electrically independent from the first metallic plates 400A.

In the second element group 200G2, the upper surface heat spreader 201 is connected to the single second metallic plate 400B via the thermal conductive members 300. In other words, the four upper surface heat spreaders 201 of the four heating elements 200 are electrically connected to the single second metallic plate 400B via the thermal conductive members 300. Therefore, the electrical potentials of the four upper surface heat spreaders 201 are mutually the same.

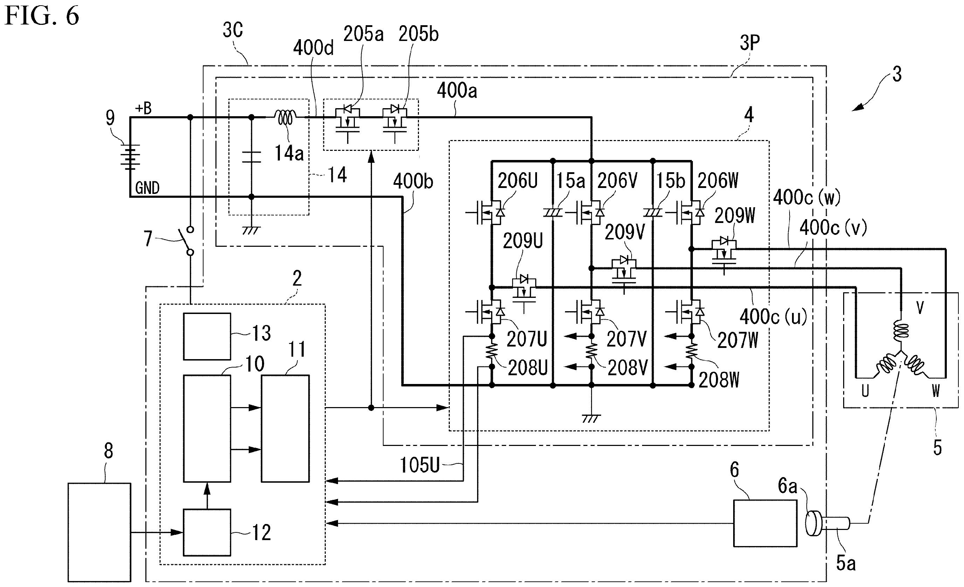

The second metallic plate 400B shown in FIG. 4A for example, is a wiring that corresponds to reference sign 400a that is shown in the circuit block diagram shown in FIG. 6

<Shunt Resistors and Third Substrate Connection Structure>

The shunt resistors 204 have electrodes 204E. The electrodes 204E of the shunt resistors 204 are joined by soldering to the circuit pattern 100P of the substrate 100. Third metallic plates 400C are provided between the positions 204R where the electrodes 204E join the circuit pattern 100P, and the thermal conductive insulators 500.

As shown in FIG. 4A, the third metallic plates 400C to which the three shunt resistors 204 are electrically connected to are mutually independent from one another. In other words, two third metallic plates 400C between two shunt resistors 204 adjacent to one another are not electrically connected.

In the explanation below, there are cases where the first element group 200G1 and the second element group 200G2 are simply referred to as an "element group 200G". There are cases where the first metallic plates 400A, the second metallic plate 400B, and the third metallic plates 400C are simply referred to as "metallic plate 400". There are cases where the first element group 200G1 is referred to as an "upper level element group 200G1 ". There are cases where the second element group 200G2 is referred to as a "lower lever element group 200G2".

When using the eight heating elements 200 as inverters, the plurality of heating elements 200 that configure the first element group 200G1 are connected to a plurality of the first metallic plates 400A. The plurality of heating elements 200 that configure the second element group 200G2 are connected to the single second metallic plate 400B. As such, it is possible to have the first metallic plates 400A and the second metallic plate 400B function properly as electrical wiring members. As a result, it is possible to improve the wiring density of the electronic device 2.

In the example shown in FIG. 4A to FIG. 4C, although a number of the element groups arranged in the Y direction (the first element group 200G1, the second element group 200G2) is two, the number of the element groups may be a number greater than or equal to two.

In other words, a number of rows of the plurality of the first metallic plates 400A disposed along in the X direction may be greater than or equal to two (a plurality of metallic plates 400). A number of the second metallic plates 400B that extend in the X direction may be greater than or equal to two (the plurality of metallic plates 400). When the number of rows of the metallic plates is greater than or equal to three, two of the selected rows of the metallic plates correspond to the plurality of the first metallic plates 400A, and the second metallic plate 400B.

It is possible to design a flat surface pattern of the metallic plates 400 (the first metallic plates 400A, the second metallic plate 400B, and the third metallic plates 400C) to be wider as well as thicker than the circuit pattern 100P formed on the substrate 100. For such reason, it is possible to pass a large current through the metallic plates 400. Configurations of the metallic plates 400 shown in FIG. 4A to FIG. 4C are similar to the explained configurations of the previously mentioned embodiments shown in FIG. 1 to FIG. 3.

When a large current is supplied to the metallic plates 400, the metallic plates 400 generate heat due to the electrical resistivity of the materials that configure the metallic plates 400. However, since the metallic plates 400 are thermally connected to the thermal conductive insulators 500 via the heat sink 600, the heat that is generated by the metallic plates 400 is sufficiently dissipated from the heat sink 600. For such reason, it is possible to pass a large current through the metallic plates 400 without consideration of the heat that is generated from the metallic plates 400.

Conversely, when an amount of the current supplied to the metallic plates 400 is not changed, it is possible design the metallic plates 400 to be fine as well as thin. In such a case, it is possible to downsize the electronic device 2, and it is possible to reduce the cost of manufacturing the electronic device 2.

The four heating elements 200 that configure the first element group 200G1 (upper level element group) shown in FIG. 4A for example, correspond to each of reference signs 400c (u), 400c (v), 400c (w), and 400d that are shown in the circuit block diagram shown in FIG. 6 to be mentioned later on. Each of the upper surface heat spreaders 201 (drain electrodes) of the four heating elements 200 that configure the first element group 200G1 is mutually independent regarding the electrical potential. Further, it is not possible to electrically connect the plurality of the metallic plates 400 (the plurality of first metallic plates 400A) disposed in the first element group 200G1 to the other metallic plates 400 (the second metallic plate 400B). For such reason, when disposing two mutually independent metallic plates 400 separately, an assembly step of the electronic device 2 becomes complicated.

In the present embodiment, insulating members 800 gather the plurality of the first metallic plates 400A, the second metallic plate 400B, and the third metallic plates 400C, which are mutually independent, together as one part, while insulating each from the other. In other words, a single part is configured from the plurality of the first metallic plates 400A, the second metallic plate 400B, the third metallic plates 400C, and the insulating members 800. As such, the assembly step of the electronic device 2 becomes easier. It is possible to use a well-known insulation material as the insulation material that configures the insulating members 800.

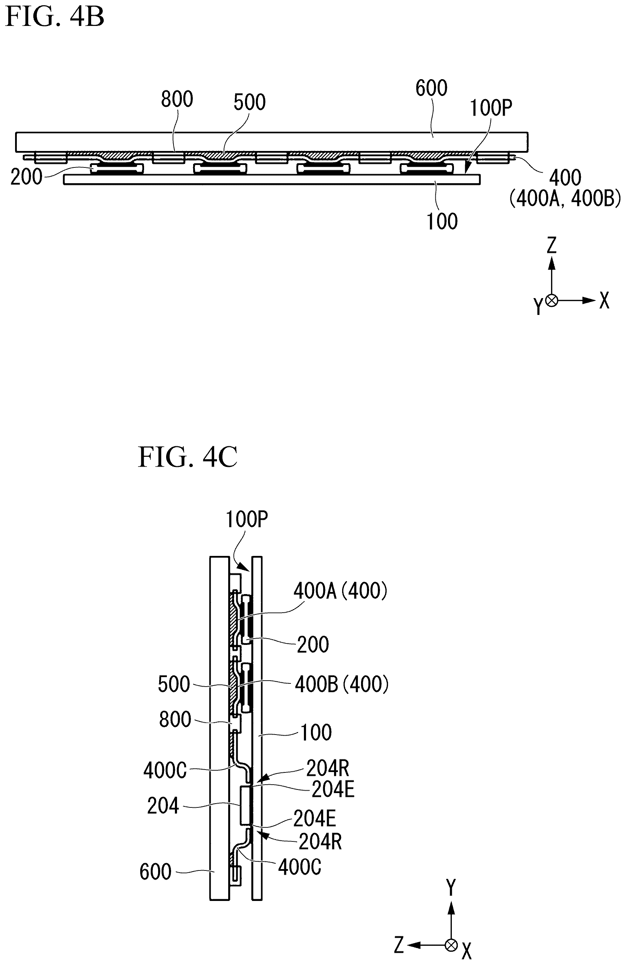

As shown in FIG. 4B, thicknesses of the thermal conductive insulators 500 are determined by thicknesses of the insulating members 800. As such, it is possible for the insulating members 800 to function as spacers. In other words, before disposing the thermal conductive insulators 500 between the metallic plates 400 and the heat sink 600, the gap between the metallic plates 400 and the heat sink 600 is determined by the insulating members 800. Structures, the materials, and the shapes of the spacers for example, are similar to the structures, the materials, and the shapes of the spacers 501 shown in FIG. 2.

The gap formed by the insulating members 800 is filled by the thermal conductive insulators 500. As such, it is possible to assuredly dispose the thermal conductive insulators 500 between the metallic plate 400 and the heat sink 600. In other words, the thicknesses of the thermal conductive insulators 500 are determined by the insulating members 800.

On a top surface of the heating elements 200, parts that do not have heat spreaders, for example, parts such as the shunt resistors exist. In the cross-sectional view of FIG. 4C, a state where a shunt resistor 204 of the shunt resistors 204 that are mounted onto the electronic device 2 is shown. The shunt resistors 204 are mounted on the first surface 100F of the substrate 100.

The shunt resistor 204 is a surface mounted resistor element (heat generating part). The shunt resistor 204 has the electrodes 204E mounted on both sides of the shunt resistor 204. The electrodes 204E of the shunt resistor 204 are joined by soldering to the circuit pattern 100P of the substrate 100. The heat generated by passing a current through the shunt resistor 204 is mainly dissipated, passing through from the electrodes 204E to the circuit pattern 100P. However, the thermal conductivity of the material that configures the circuit pattern 100P or the substrate 100 has a very small having bad thermal conductivity.

As shown in FIG. 4C, the third metallic plates 400C are joined by soldering to the positions 204R, where the electrodes 204E of the shunt resistor 204 are joined by soldering to the circuit pattern 100P of the substrate 100.

Specifically, portions of the third metallic plates 400C that are disposed in the positions 204R are bent so as to form an S shape when seen in the cross-sectional view. The bent third metallic plates 400C are joined to the circuit pattern 100P in the positions 204R. As such, heat generated by the shunt resistors 204 or the circuit pattern 100P is dissipated from the heat sink 600 via the positions 204R of the electrodes 204E, the third metallic plates 400C, and the thermal conductive insulators 500.

As previously mentioned, the electronic device 2, has the first metallic plates 400A, the second metallic plate 400B, and the third metallic plates 400C. By making an area of the thermal conductive insulators 500 that face the heat sink 600 and an area of the metallic plates 400A, 400B and 400C wider, it is possible to decrease the thermal resistivities thereof.

Although not shown in FIG. 4A to FIG. 4C, in a case where a large current is passed between two element terminals 203 in a structure where the two element terminals 203 of the heating elements 200 are connected to the circuit pattern 100P, the third metallic plates 400C may be attached by soldering to the circuit pattern 100P. As such, it is possible to dissipate heat from the heat sink 600 via the third metallic plates 400C and the thermal conductive insulators 500, and it is possible to decrease the thermal resistivities thereof.

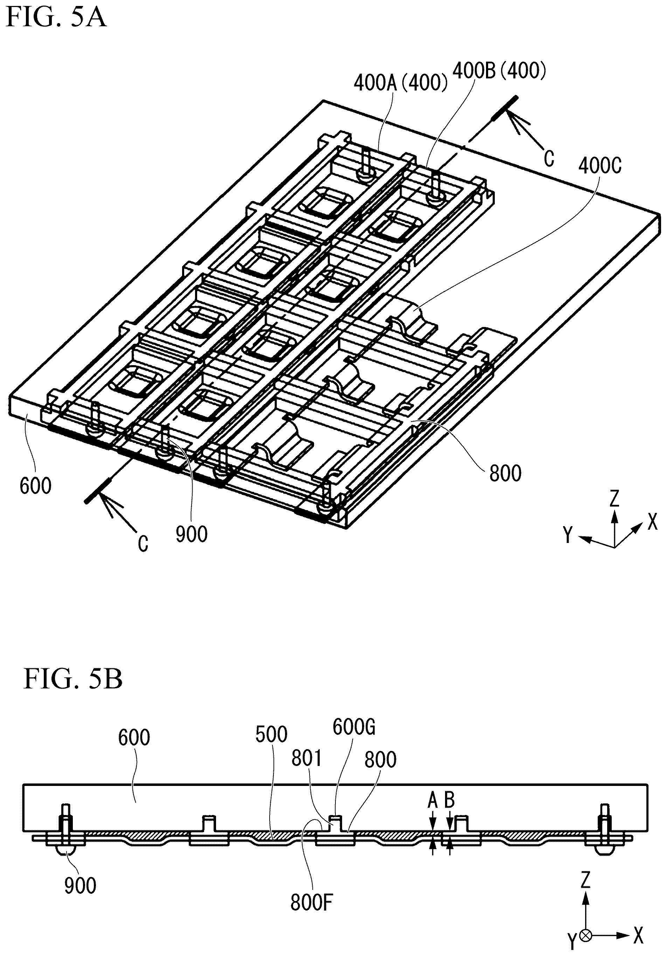

Next, a structure that decreases the thermal resistivity is explained with reference to FIG. 5A and FIG. 5B.

The substrate 100 and the heating elements are omitted from FIG. 5A and FIG. 5B.

The insulating members 800 mutually insulates and fixes the metallic plates 400A, 400B and 400C. A single part is formed by the metallic plates 400A, 400B, 400C, and the insulating members 800. Dimension A in FIG. 5B indicates a thickness of the thermal conductive insulator 500. As previously mentioned, as the above thickness (dimension A) gets thinner, it is possible to make the heat resistivity smaller, and it is possible to improve the heat dissipating function thereof.

In an actual manufacturing step of the electronic device 2, thicknesses of the thermal conductive insulators 500 (dimension A) need to be determined after considering dimension tolerances and assembly tolerances of the parts that configure the electronic device 2. However, unnecessarily downsizing the dimensional tolerances and the assembly tolerances invites an increase in manufacturing costs of the electronic device 2.

In a case where the insulating members 800, the metallic plates 400A, 400B, and 400C are formed by insert molding for example, a single mold is used, and it is possible to integrally form the metallic plates 400A, 400B, 400C and the insulating members 800. For such reason, achieving smaller tolerances of the thicknesses of the insulating members 800 (dimension B) at a low cost and with relative ease is possible.

Regarding a fixed structure of the insulating members 800 with respect to the heat sink 600, by fixing the insulating members 800 so as to press directly against the heat sink 600 for example, it is possible to control the thicknesses of the thermal conductive insulators 500 by adopting a fixed structure that uses screws 900. As a result, it is possible to design the electronic device 2 that has a small heat resistivity, and has a high heat dissipating function at a low cost.

In a case where a strength of fixation of the metallic plates 400A, 400B, and 400C decreases due to the thicknesses of the insulating members 800 (dimension B) becoming smaller, ribs 801 may be provided on the insulating members 800. The ribs 801 are provided on end surfaces 800F of the insulating members 800 that face the heat sink 600.

In a structure that uses the insulating members 800 which include the ribs 801, grooves 600G in the heat sink 600 are provided in locations that correspond to the locations of the ribs 801.

By having the ribs 801 be inserted into the grooves 600G, the insulating members 800 and the heat sink 600 are fixed. Therefore, even in a case where the thicknesses of the insulating members 800 (dimension B) are small, by adopting a structure where the ribs 801 are fitted into the grooves 600G, a size of the electronic device 2 is kept from becoming large in the Z direction, and it is possible to realize a positional function when attaching the insulating members 800 to the heat sink 600.

<Effects>

Next, effects of the electronic device 2 are explained.

According to the electronic device 2, it is possible to obtain same or similar effects as the effects of the electronic device 1 according to the first embodiment previously mentioned. In a case where the electronic device 2 includes the plurality of heating elements 200, it is possible to integrally form the first metallic plates 400A, the second metallic plate 400B, and the third metallic plates 400C. By fixing the plurality of metallic plates 400A, 400B, and 400C with the insulating members 800, it is possible to have the thicknesses of the thermal conductive insulators 500 be thinly set, as determined by the thicknesses of the insulating members 800. As such, it is possible to achieve a high heat dissipating structure. By disposing parts of another control circuit or the like a top of the second surface 100S of the substrate 100, it is possible to realize a downsized as well as low cost electronic device 2.

Since heat generated by the circuit pattern 100P is also dissipated via the metallic plates 400C, there is no need to use a large thick copper substrate that allows a large current to be passed through, which makes it possible to decrease the cost of the electronic device 2.

<Modification Example of Second Embodiment>

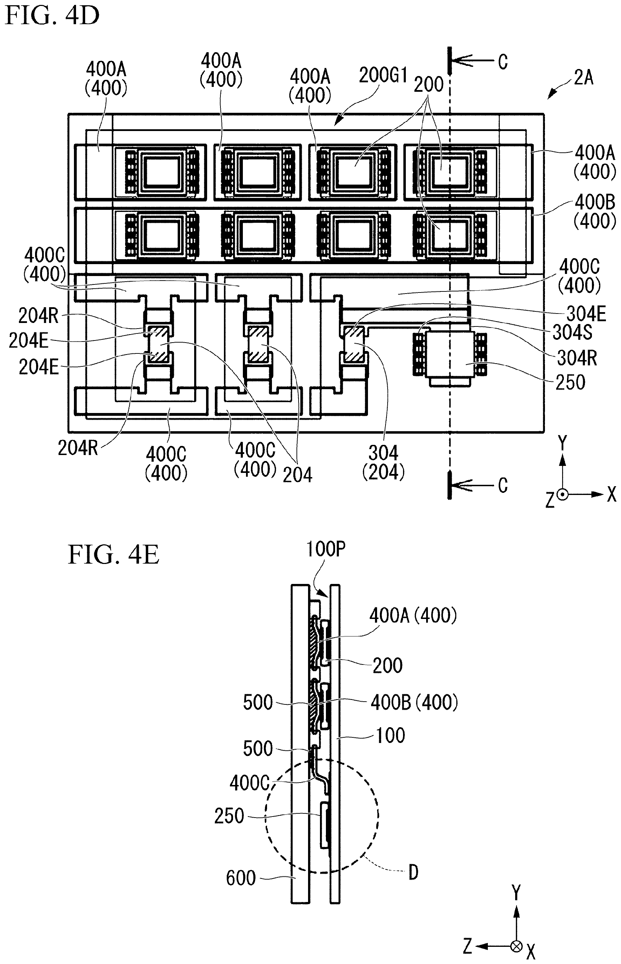

Next, a modification example of the second embodiment is explained with reference to FIG. 4D to FIG. 4F. The modification example of the second embodiment differs from the second embodiment in the aspect of the connection structure of third metallic plates 300C. In FIG. 4D to FIG. 4F, same components as components of the electronic device 1 shown in FIG. 1 to FIG. 3 and of the electronic device 2 shown in FIG. 4A to FIG. 4C have same reference signs affixed to them, and explanations thereof are omitted or simplified.

As shown in FIG. 4D to FIG. 4F, along with a structure of the electronic device 2 shown in FIG. 4A, an electronic device 2A according to the modification example of the second embodiment includes a heating element 250 that functions as the power MOS-FET.

<Heat Generating Elements>

The heating element 250 has the same structure as a heating element 200 of the heating elements in FIG. 1, and includes the lower surface heat spreader 202. The lower surface heat spreader 202 is the drain electrode or a source electrode of the heating element 250. The heating element 250 is adjacently disposed to a right side shunt resistor 304 out of the three shunt resistors 204 located in the most right side of the shunt resistors 204 in the X direction.

<Modification Example of Third Metallic Plates>

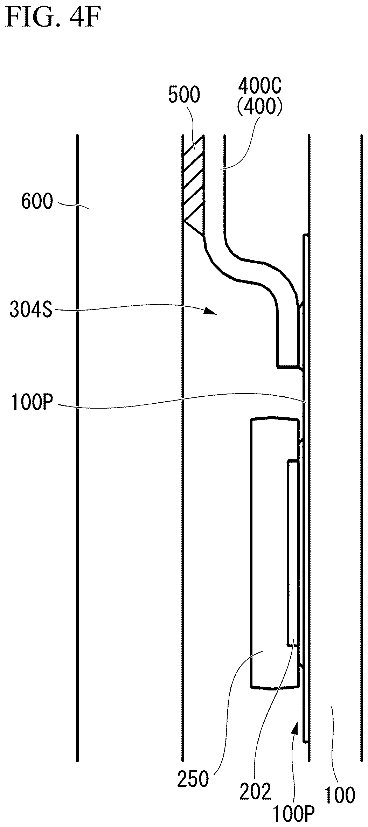

A third metallic plate 400C out of the metallic plates 400C is connected to an electrode 304E of a side of the right side shunt resistor 304 and to the lower surface heat spreader 202 of the heating element 250 via the circuit pattern 100P. As shown in FIG. 4E and FIG. 4F, the third metallic plate 400C is connected to the heat sink 600 via the thermal conductive insulator 500. The third metallic plates 400C is formed of the same material as the material of the previously mentioned metallic plates 400.

Specifics of the connection structure of the electrode 304E and the third metallic plate 400C, and of the connection structure of the lower surface heat spreader 202 and the third metallic plate 400C are explained below.

The electrode 304E of the right side shunt resistor 304 is joined by soldering to the circuit pattern 100P of the substrate 100 in a position 304R. The third metallic plate 400C is joined by soldering to the above position 304R. A portion of the third metallic plate 400C that is disposed in the position 304R is bent so as to form an S shape when seen in the cross-sectional view.
The bent portion of the third metallic plate 400C is joined to the circuit pattern 100P at the position 304R. As such, the electrode 304E and the third metallic plate 400C are connected via the position 304R.

The lower surface heat spreader 202 of the heating element 250 is joined by soldering to the circuit pattern 100P of the substrate 100 at a position 304S. The third metallic plate 400C is joined by soldering to the above position 304S. The portion of the third metallic plate 400C disposed in the position 304S is bent so as to form an S shape when seen in the cross-sectional view. The bent portion of the third metallic plate 400C is joined to the circuit pattern 100P at the position 304S. As such, the lower surface heat spreader 202 and the third metallic plate 400C are connected via the position 304S.

In the connection structures mentioned above, the electrode 304E of a side of the right side shunt resistor 304, and the lower surface heat spreader 202 of the heating element 250 are electrically connected via the circuit pattern 100P and the third metallic plate 400C. For such reason, the electrode 304E and the lower surface heat spreader 202 have the same electrical potential.

Further, both the right side shunt resistor 304 and the heating element 250 are heat generating parts, and heat that is generated from these parts is dissipated to the heat sink 600 via the third metallic plate 400C and the thermal conductive insulators 500. Heat that is generated from the circuit pattern 100P is dissipated to the heat sink 600 via the third metallic plates 400C and the thermal conductive insulators 500.

Therefore, it is possible to obtain same or similar effects from the electronic device 2A as the previously mentioned electronic device 2 according to the second embodiment. Specifically, it is possible to dissipate heat generated from the right side shunt resistor 304, the heating element 250, and the circuit pattern 100P to the heat sink 600 by the third metallic plates 400C. For such reason, it is possible to further reduce the cost of the electronic device 2A without needing to use a copper substrate having a large thickness required to pass a large current through.

Third Embodiment

In the first and second embodiments, a case where a single heating element 200 is included in the electronic device 1, and a case where a plurality of heating elements 200 are included in the electronic device 2, 2A is explained. In a third embodiment, a case where an electronic device provided with a plurality of heating elements is applied to an electric power steering device is explained.

In FIG. 6 to FIG. 8B, same configurations as configurations shown in FIG. 1 to FIG. 5B have same reference signs affixed to them, and explanations thereof are omitted or simplified

In FIG. 6, wiring shown with a thick line (reference signs 400a, 400b, 400c, 400d) corresponds to wiring through which a large current flows through. Parts included in a wiring path shown in the wiring 400a, 400b, 400c, and 400d are heat generating parts (the heating elements 200).

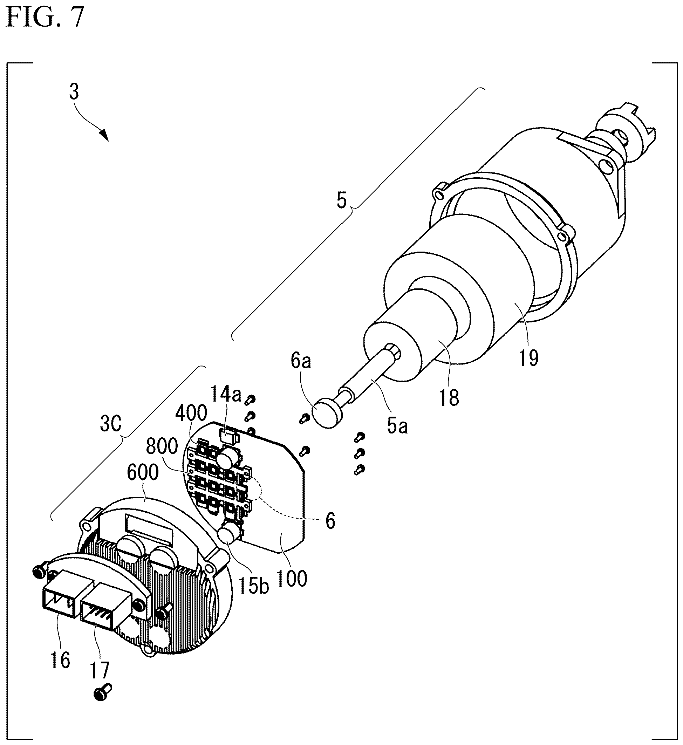

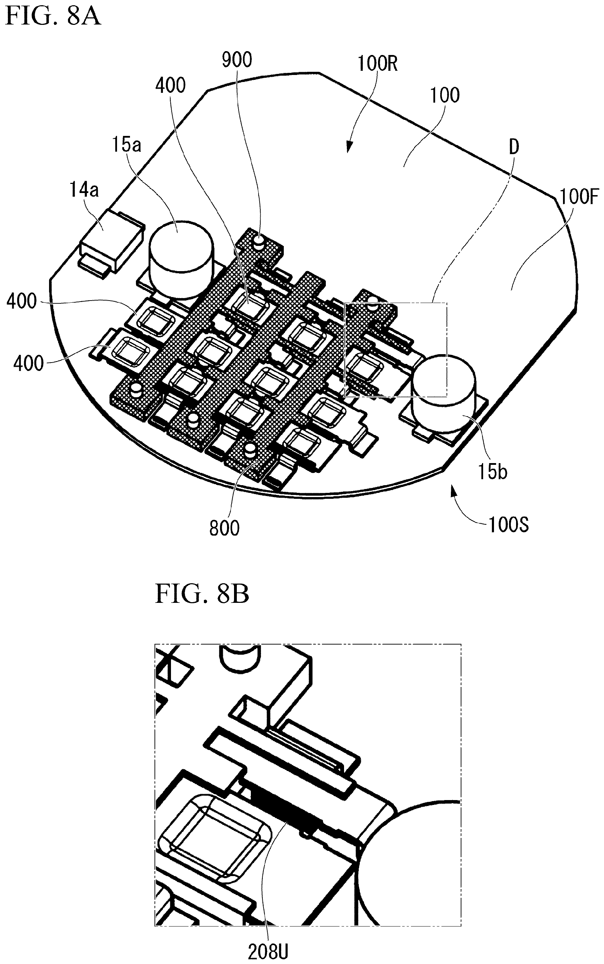

FIG. 7 is an exploded view of a motor and a controller that configure an electric power steering device 3. FIG. 8A and FIG. 8B are inclined views that show a substrate that configures the electric power steering device 3.

The electric power steering device 3 includes a control device 3C, a reduction gear not shown, an electric motor 5, a torque sensor 8, and a battery 9. The electric power steering device 3 further includes a power connector 16 and a vehicle side signal connector 17.

The control device 3C controls a drive of the electric motor 5. The reduction gear not shown reduces a rotational speed of the electric motor 5. The electric motor 5 outputs an auxiliary torque with respect to the vehicle steering wheel. The electric motor 5 is three-phase brushless motor. The electric motor 5 includes a rotor 18 and a stator 19 having armature coils UVW. The torque sensor 8 detects a steering torque of the steering wheel. The battery 9 supplies the electric motor 5 with current to drive the electric motor 5. The power connector 16 electrically connects the battery 9 and the control device 3C. The vehicle side signal connector 17 electrically connects the torque sensor 8 and other control terminals of the torque sensor 8, and the control device 3C.

The control device 3C includes capacitors 15a, and 15b, shunt resistors 208U, 208V, and 208W, semiconductor switching elements 206U, 206V, 206W, 207U, 207V, and 207W, semiconductor switching elements 209U, 209V, and 209W, a coil 14a, and semiconductor switching elements 205a, and 205b.

The control device 3C also includes a rotation sensor 6, a microcomputer 10, a drive circuit 11, and the substrate 100.

<Capacitors>

The capacitors 15a, and 15b are large-capacity capacitors for absorbing ripple components of a motor current IM flowing through the electric motor 5. The capacitors 15a, and 15b are for example, ripple capacitors.

<Shunt Resistors>

The shunt resistors 208U, 208V, and 208W detect the motor current IM.

There are cases where the shunt resistors 208U, 208V, and 208W are referred to as a "shunt resistor 208".

<Semiconductor Switching Elements>

The semiconductor switching elements that configure the control device 3C are the previously mentioned heating elements 200 (for example, FETs).

The semiconductor switching elements 206U, 206V, 206W, 207U, 207V, and 207W configure the three-phase bridge circuit. Such semiconductor switching elements change a direction of the motor current 1M according to the size and the direction of the auxiliary torque.

In the explanation below, there is a case where the semiconductor switching elements 206U, 206V, and 206W are referred to as a "semiconductor switching element 206". There is a case where the semiconductor switching elements 207U, 207V, and 207W are referred to as a "semiconductor switching element 207".

The semiconductor switching elements 209U, 209V, and 209W configure a motor relay. Such a motor relay is a switch to pass/cut off the motor current IM supplied to the electric motor 5 from the bridge circuit.

The semiconductor switching elements 205a and 205b configure a power supply relay. Such a power supply relay functions as a switch to pass/cut off a battery current IB supplied to the bridge circuit from the battery 9.

In the explanation below, there is a case where the semiconductor switching elements 209U, 209V, and 209W are referred to as a "semiconductor switching element 209".

<Coil>

The coil 14a prevents electromagnetic noise that is generated when the semiconductor switching elements 206 and 207 are in switching operation, from being discharged to an outside, becoming radio noise.

<Rotation Sensor>

The rotation sensor 6 is a rotation position sensor that detects the rotation position of the rotor 18.

<Microcomputer>

The microcomputer 10 calculates the auxiliary torque based off of a steering torque signal that is output from the torque sensor 8. The microcomputer 10 conducts feedback control based off of the motor current IM that flows into the electric motor 5, and the rotation position of the rotor of the electric motor 5 detected at the rotation sensor 6. The microcomputer 10 calculates the current that corresponds to the auxiliary torque.

The microcomputer 10 has a function of an AD converter and of a PWM timer circuit or the like. The microcomputer 10 also has a well-known self-diagnosis, and is constantly conducting a self-diagnosis on whether a system of the electric power steering device 3 is operating correctly or not. When the microcomputer 10 detects an abnormality, the microcomputer 10 cuts off the supply of motor current IM.

The steering torque that is output from the torque sensor 8 is input into the microcomputer 10. Information of the rotation position of the rotor of the electric motor 5 from the rotation sensor 6 is input into the microcomputer 10. A traveling speed signal, which is a signal out of vehicle side signals, from the vehicle side signal connector 17 is input into the microcomputer 10. Feedback is input into the microcomputer 10 by the motor current IM passing through the shunt resistor 208. From the information and the signals above, a current control amount that corresponds to a rotation direction command of power steering is generated in the microcomputer 10. A drive signal is input into the drive circuit 11.

<Drive Circuit>

The drive circuit 11 outputs the drive signal that controls the operation of the semiconductor switching elements 206 and 207, based off of a command that is output from the microcomputer 10.

The drive circuit 11 generates a PWM drive signal after the rotation direction command and the current control amount are input into the drive circuit 11. The drive circuit 11 applies the PWM drive signal to the semiconductor switching elements 206 and 207. As such, the current supplied from the battery 9 flows through the power connector 16, the coil 14a, and the semiconductor switching elements 205a and 205b in the electric motor 5. As a result, a predetermined amount of auxiliary torque that is supplied in a predetermined direction is output.

At such time, the motor current IM that is detected through the shunt resistor 208 and current detection methods is feedbacked to the microcomputer 10. As such, control is conducted so that the motor current IM sent to the drive circuit 11 from the microcomputer 10, and the motor current IM match one another. Although the motor current IM includes ripple components from the switching operation when the PWM drive of the semiconductor switching elements 206 and 207 operates, the motor current IM is controlled by the large-capacity capacitors 15a and 15b so as to be smooth.

<Substrate>

As mentioned in the first and second embodiments, the plurality of heating elements 200 are mounted on the top of the substrate 100. The substrate 100 mounts the shunt resistor 208, the microcomputer 10, and the drive circuit 11.

A power portion 3P shown in FIG. 6 is mounted in the substrate 100.

Specifically, as shown in FIG. 8A and FIG. 8B, the top of the substrate 100 has a portion that is formed of the coil 14a shown in FIG. 6 (EMI noise filter), a power supply relay 205a and 205b, the semiconductor switching elements 206 and 207 of an inverter portion, the shunt resistor 208 for detecting current, the capacitors 15a and 15b, and the semiconductor switching elements 209 being mounted on the top of the substrate 100.

As explained in the first and second embodiments, a substrate 100 having such a configuration has a structure that dissipates heat to the heat sink 600 from the metallic plates 400 (400A, 400B, 400C) via the thermal conductive insulators 500. The thermal conductive insulators 500 and the heat sink 600 are omitted from FIG. 8A and FIG. 8B. A structure of the adopted semiconductor switching elements (FETs, heating elements 200) shown in FIG. 8A and FIG. 8B has the upper surface heat spreader 201. Top surface electrodes of the semiconductor switching elements are drain electrodes.

As shown in FIG. 8A, no components are disposed on the region 100R located on a top right portion in the first surface 100F of the substrate 100. Likewise, no components are disposed on the second surface 100S of the substrate 100. In other words, the region 100R and the second surface 100S are empty spaces.

As such, in the region 100R and the second surface 1005, it is possible to mount parts other than parts that configure the power portion 3P in the circuit block shown in FIG. 6. Specifically, it is possible to mount a supply circuit 13, the microcomputer 10, the drive circuit 11, an input circuit 12, a rotation sensor 6, and various interfaces or the like that belong to the control circuit.

<Effects>

Next, effects of the electric power steering device 3 are explained.

According the electric power steering device 3, it is possible to obtain same or similar effects as the effects previously mentioned in the electronic device 1, 2 and 2A. Although the electric power steering device 3 includes a plurality of semiconductor switching elements which are heating elements, it is possible for the electric power steering device 3 to dissipate heat generated from the semiconductor switching elements via the metallic plates 400 (400A, 400B, 400C), the thermal conductive insulators 500, and the heat sink 600 to the outside of the electric power steering device 3.

Fourth Embodiment

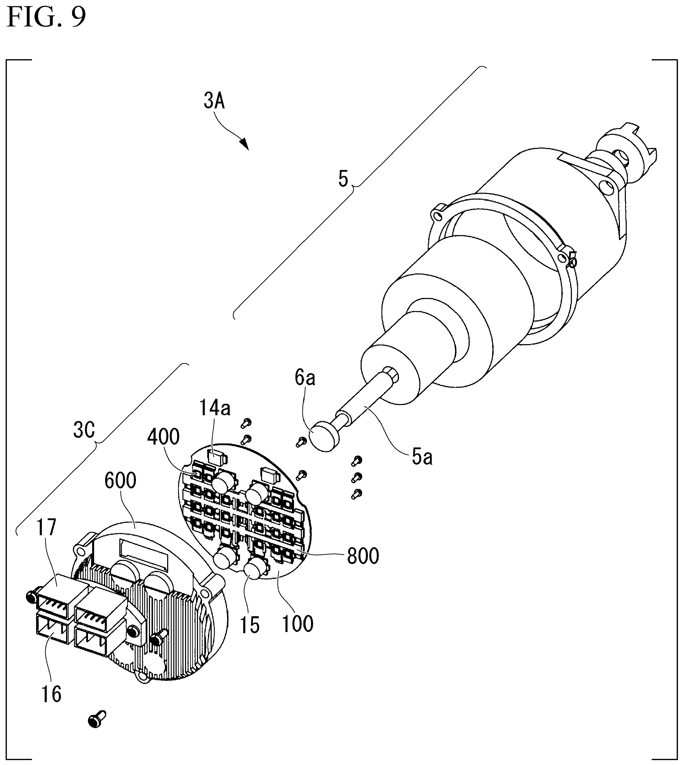

FIG. 9 is an exploded view of a motor and a controller that configure a redundant electric power steering device 3A which assumes a complete dual system.

In recent years, with a rise in demand for safe design of electric power steering devices, demand for redundant electric power steering devices exists. FIG. 9 shows an example of a redundant electric power steering device. In FIG. 9, same components as configurations shown in FIG. 1 to FIG. 8B have same reference signs affixed to them, and explanations thereof are omitted or simplified.

In the redundant electric power steering device 3A shown in FIG. 9, an electronic device that includes a plurality of heating elements (semiconductor switching elements) is applied. The redundant electric power steering device 3A has a circuit configuration that includes two of the circuit block diagrams shown in FIG. 6. In other words, the redundant electric power steering device 3A includes a dual circuit. Almost all of the parts that configure the electric power steering device 3 according to the previously mentioned third embodiment are required for the dual system in the redundant electric power steering device 3A. As such, a mounting area onto which it is possible to mount parts on the substrate 100 expands.

<Effects>

With respect to the above, it is possible to dissipate the heat generated from the semiconductor switching elements in the redundant electric power steering device 3A to the outside of the redundant electric power steering device 3A via the metallic plates 400 (400A, 400B, 400C), the thermal conductive insulators 500, and the heat sink 600. As such, it is possible to keep an increase in a volume or the area of the substrate 100 as the number of parts increase to a minimum. It is also possible to downsize the redundant electric power steering device 3A without any sacrifice in the heat dissipating function thereof, and it is possible to achieve a low cost redundant electric power steering device 3A.

[Reference Signs List]

1, 2, 2A... Electronic Device 3... Electric Power Steering Device 3a... Redundant Electric Power Steering Device 3C...Control Device 3P...Power Portion 5... Electric Motor 6...Rotation Sensor 8... Torque Sensor 9... Battery 10...Microcomputer 11... Drive Circuit 12... Input Circuit 13...Supply Circuit 14a...Coil (EMI Noise Filter) 15a, 15b... Capacitor 16... Power Connector 17...Vehicle Side Signal Connector 18...Rotor 19...Stator 100...Substrate 100F...First Surface 100P...Circuit Pattern 100R... Region 100S...Second Surface 101... Connection Terminal 200, 250...Heating Elements 200G1...First Element Group (Upper Elements Group) 200G2...Second Element Group (Lower Elements Group) 200R...Region 201...Upper Surface Heat Spreader (Upper Surface Heat Dissipating Portion) 202... Lower Surface Heat Spreader (Surface Facing Substrate) 203... Element Terminal 204...Shunt Resistors 204E, 304E...Electrodes 204R, 304R, 304S...Positions 205a, 205b...Power Supply Relay (Semiconductor Switching Elements) 206, 206U, 206V, 206W... Semiconductor Switching Elements 207, 207U, 207V, 207W...Semiconductor Switching Elements 208, 208U, 208V, 208W...Shunt Resistors 209, 209U, 209V, 209W...Semiconductor Switching Elements 300... Thermal Conductive Member 304... Right Side Shunt Resistor 400a...Wiring 400A...First Metallic Plate 400b...Wiring 400B...Second Metallic Plate 400C...Third Metallic Plate 400c, 400d...Wiring 400F...First Metallic Surface 400R...Bottom Surface 400S...Second Metallic Surface 400I...Inclined Surface 400T...End Surface 401...Protrusion 402...Recess 500...Thermal Conductive Insulators 501...Spacer 600...Heat Sink 600G... Grooves 800...Insulating Members 801...Ribs 800F...End Surface 900... Screws

**Claims**

1. An electronic device comprising:

   a substrate having a circuit pattern;
   heating elements disposed on a top of the substrate, and that have upper surface heat dissipating portions that are located on an opposite side of the substrate;
   thermal conductive members that are disposed on a top of the upper surface heat dissipating portions;
   metallic plates that are disposed on a top of the thermal conductive members;
   thermal conductive insulators that are disposed on a top of the metallic plates, and
   a heat sink that is disposed on a top of the thermal conductive insulators.

2. The electronic device according to claim 1, wherein: thermal conductivities of the thermal conductive members are larger than the thermal conductivities of the thermal conductive insulators.

3. The electronic device according to claim 1, wherein: an area of contact between the metallic plates and the thermal conductive insulators is larger than the area of contact between the heating elements and the thermal conductive members.

4. The electronic device according to claim 1, wherein:

   the thermal conductive members are provided between the upper surface heat dissipating portions and the metallic plates, and
   solder is a material of the thermal conductive members.

5. The electronic device according to claim 1, wherein:

   the thermal conductive insulators are provided between the metallic plates and the heat sink, and
   a material of the thermal conductive insulators is a heat conductive grease or a heat conductive adhesive.

6. The electronic device according to claim 1, wherein:

   spacers that determine gaps between the metallic plates and the heat sink are provided, and the thermal conductive insulators are filled between the gaps that are determined by the spacers between the metallic plates and the heat sink.

7. The electronic device according to claim 1 further comprising:

   a plurality of heating elements, that each have the upper surface heat dissipating portions located on an opposite side to the substrate, and that correspond to the heating elements each, and
   a plurality of first metallic plates that are disposed on the top of the thermal conductive members, that are also disposed so as to face an arrangement direction of the plurality of heating elements, and that are mutually apart, wherein
   the upper surface heat dissipating portions are connected to each of the plurality of first metallic plates via the thermal conductive members.

8. The electronic device according to claim 1 further comprising:

   a plurality of heating elements, that each have the upper surface heat dissipating portions located on an opposite side to the substrate, and that correspond to the heating elements each, and
   a second metallic plate that is disposed on the top of the thermal conductive members, that also extends in the arrangement direction of the plurality of heating elements, and that causes each of the plurality of heating elements to be conductive with one another, wherein
   the upper surface heat dissipating portions are connected to the second metallic plate via the thermal conductive members.

9. The electronic device according to any one of claims 1 to 8 further comprising:

   heating parts that have electrodes that are joined to the circuit pattern by soldering, and
   a third metallic plate provided between a location where the electrodes and the circuit pattern are joined, and the thermal conductive insulators.

10. The electronic device according to claim 9, wherein the third metallic plate is joined to the circuit pattern by soldering.

11. The electronic device according to claim 9, wherein a single part has:

   the first metallic plates that are disposed on the top of the thermal conductive members;
the second metallic plate that is disposed on the top of the thermal conductive members, and is electrically independent from the first metallic plates, and
thermal insulation members that insulate the first metallic plate, the second metallic plate, and the third metallic plate, and wherein
the single part is configured of the first metallic plates, the second metallic plate, the third metallic plate, and the thermal insulation members.

12. The electronic device according to claim 11, wherein thicknesses of the thermal insulation members are determined by thicknesses of the thermal conductive insulators.

13. The electronic device according to claim 11 wherein

the thermal insulation members further comprise:
ribs that are provided on end surfaces that face the heat sink, and
the heat sink further comprises:
grooves provided at locations that correspond to the ribs, and wherein
the ribs are inserted into the grooves.

14. An electric power steering device comprising:

a substrate having a circuit pattern;
heating elements disposed on a top of the substrate, and that have upper surface heat dissipating portions that are located on an opposite side of the substrate;
thermal conductive members that are disposed on a top of the upper surface heat dissipating portions;
metallic plates that are disposed on a top of the thermal conductive members;
thermal conductive insulators that are disposed on a top of the metallic plates, and
a heat sink that is disposed on a top of the thermal conductive insulators.

# FIG. 1

# FIG. 2

FIG. 3

FIG. 4A

FIG. 4B

FIG. 4C

FIG. 4D

FIG. 4E

# FIG. 4F

## FIG. 5A

## FIG. 5B

FIG. 6

EP 4 379 792 A1

FIG. 7

FIG. 8A

FIG. 8B

208U

FIG. 9

## INTERNATIONAL SEARCH REPORT

| | International application No. |
|---|---|
| | PCT/JP2021/027530 |

**A. CLASSIFICATION OF SUBJECT MATTER**
H01L 23/36(2006.01)i
FI: H01L23/36 D

According to International Patent Classification (IPC) or to both national classification and IPC

**B. FIELDS SEARCHED**

Minimum documentation searched (classification system followed by classification symbols)
H01L23/36

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2008-130879 A (DENSO CORP) 05 June 2008 (2008-06-05) paragraphs [0001]-[0090], fig. 3, 11 | 1-5, 7-10, 14 |
| Y | paragraphs [0001]-[0090], fig. 3, 11 | 6 |
| A | entire text, all drawings | 11-13 |
| Y | JP 2008-277330 A (MITSUBISHI ELECTRIC CORP) 13 November 2008 (2008-11-13) paragraphs [0014]-[0023], fig. 1-4 | 6 |
| A | entire text, all drawings | 1-5, 7-14 |

☐ Further documents are listed in the continuation of Box C.  ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 September 2021 (10.09.2021) | 21 September 2021 (21.09.2021) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**
Information on patent family members

International application No.

PCT/JP2021/027530

| Patent Documents referred in the Report | Publication Date | Patent Family | Publication Date |
|---|---|---|---|
| JP 2008-130879 A | 05 Jun. 2008 | (Family: none) | |
| JP 2008-277330 A | 13 Nov. 2008 | (Family: none) | |

Form PCT/ISA/210 (patent family annex) (January 2015)

**EP 4 379 792 A1**

**Patent documents cited in the description**

- JP 6160576 B